# EUROPEAN PATENT APPLICATION

(11) **EP 2 045 351 A1**
(43) Date of publication of application: **08.04.2009**
(21) Application number: 07425622.3
(22) Date of filing: 05.10.2007
(51) Int. Cl.: C23C 10/06, C23C 16/04, F01D 5/28

(54) **Method and plant for simultaneously coating internal and external surfaces of metal elements, in particular blades for turbines**

(71) Applicant: AVIO S.p.A., 10135 Torino (IT)
(72) Inventor: Varetti, Mauro, 10093 Collegno (IT)
(74) Representative: Bergadano, Mirko

(57) **Abstract**

Method and plant (1) for simultaneously coating internal and external surfaces of a metal item (2), whereby a gaseous mixture (19) comprising a coating agent (18) is fed towards the external surfaces of the metal item (2) to be coated and towards each of the inlets (9) of the internal passages or pipes (7, 8) of said metal item (2); simultaneously, in a continuous or pulsating way, a gaseous flow different from the entraining gaseous mixture (19) being introduced into the internal passages (7, 8) to generate a current for entraining the gaseous mixture (19) within the internal passages (7, 8) themselves.

## Description

The present invention relates to a method for simultaneously coating internal and external surfaces of metal items.

In particular, the present invention relates to a method for coating internal and external surfaces of blades for turbines, to which the ensuing treatment will make explicit reference, without this implying any loss of generality.

As is known, the production of blades for turbines comprises an operation of surface coating, during which both on the internal surfaces and on the external ones a layer of coating material is deposited, which, in use, defines a protective barrier.

Normally, in order to minimize the production times and costs, deposition of the coating material is performed simultaneously on all the surfaces and conveniently in the gas phase, i.e., impinging upon the items to be coated with a gaseous mixture comprising a coating agent. The coating agent coming into contact with the surfaces deposits on the surfaces themselves to form the protective barrier.

Even though the modality of coating described above is used, it is not altogether satisfactory above all in so far as it does not enable the same coating or degree of coating to be obtained for the internal surfaces as for the external surfaces. What has been set forth above is basically a consequence of the fact that, whilst the external surfaces are lapped by a gaseous mixture that is always rich in the aforesaid coating agent, the internal passages and/or the cavities of the blades are, instead, above all, traversed by small rates of flow of gaseous mixture on account of the sections of passage, which are normally small. Furthermore, said gaseous mixture is impoverished of the coating agent during traversal of the same passages, with the consequence that the internal surfaces have a lower degree of coating than the external one, and the degree of coating can moreover vary in an unforeseeable way in so far as it depends upon the dimensions and the geometry of the internal passages and of the cavities, in which there frequently occurs some stagnation of extremely poor mixtures.

In order to overcome the above drawback, it is known, for example from the U.S. patent No. US 5,068,127, to provide, upstream of the internal passages, a "highpressure" chamber housing the gaseous mixture, and, downstream of the same passages, a "low-pressure" chamber. The flow of gaseous mixture through the passages is regulated by varying the pressure within the "low-pressure" chamber. The modality of coating that has just been described does not altogether solve the problems presented, above all in the case where the passages are not identical to one another and, at the same time, it requires the use of specific equipment, each of which dedicated to a given type of item to be coated, with the consequence that the process is, on the one hand, costly and, on the other, does not ensure a homogeneous coating of any internal passage.

The aim of the present invention is to provide a method for simultaneously coating internal and external surfaces of metal items, in particular blades for turbines, which will enable the problems set forth above to be solved in a simple and economically advantageous way and, in particular, will enable an effective and invariant coating of any surface to be achieved at contained costs.

Provided according to the present invention is a method for simultaneously coating internal and external surfaces of a metal item, said internal surfaces delimiting at least one passage having an inlet and an outlet, the method comprising the steps of feeding a gaseous mixture comprising a coating agent towards the external surfaces of the metal item and simultaneously towards said inlet, and being characterized in that sent into said passage is a gaseous flow different from said gaseous mixture for entraining the gaseous mixture within the passage.

Preferably, in the method defined above, the gaseous entraining flow is sent within said passage through said inlet and towards said outlet.

Conveniently, said gaseous entraining flow comprises an inert gas.

The present invention moreover relates to a plant for simultaneously coating internal and external surfaces of a metal item.

Provided according to the present invention is a plant for simultaneously coating internal and external surfaces of a metal item, said internal surfaces delimiting at least one passage having an inlet and an outlet, the device comprising first means of advance for feeding a gaseous mixture comprising a coating agent towards the external surfaces of the metal item and simultaneously towards said inlet, and being characterized in that it moreover comprises second means of advance for feeding into said passage a gaseous flow different from said gaseous mixture for entraining the gaseous mixture within said passage.

Preferably, in the plant defined above, said second feed means comprises at least one delivery nozzle designed to extend through said inlet for sending said gaseous flow towards said outlet.

Conveniently, in the plant defined above, the second means of advance comprises flow-regulating means for sending a continuous or pulsating flow towards said delivery nozzle.

The invention will now be described with reference to the attached drawings, which illustrate a non-limiting example of embodiment thereof and in which:
Figure 1 is a schematic view of a preferred embodiment of a plant for implementation of the method for coating metal elements according to the present invention;
Figure 2 is a perspective view of a detail of the plant of Figure 1;
Figure 3 is a perspective view at an enlarged scale of a portion of the detail of Figure 2; and
Figure 4 is an enlarged perspective view of a part of the portion of Figure 3.

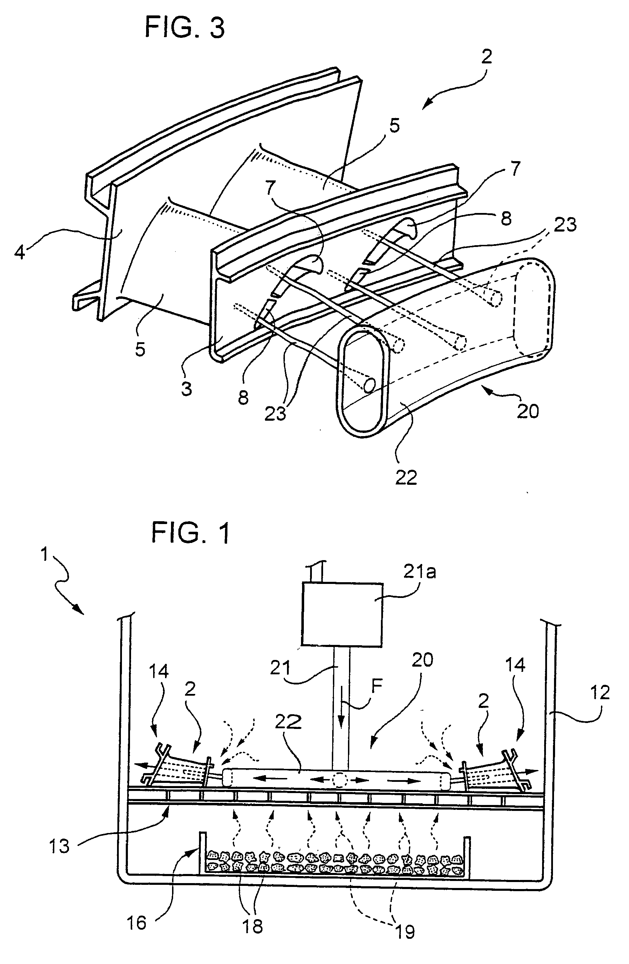

In Figure 1, designated as a whole by 1 is a plant for simultaneously coating the internal and external surfaces of a plurality of metal turbine blades 2 (not illustrated). In the particular example described, each blade 2 comprises two peripheral portions 3 and 4 and a pair of intermediate elongated portions 5, each traversed by a pair of pipes or internal passages 7, 8 communicating with the outside world through respective inlets 9 made in the peripheral portion 3 and, in the particular example described, with a common outlet 10 made in the peripheral portion 4.

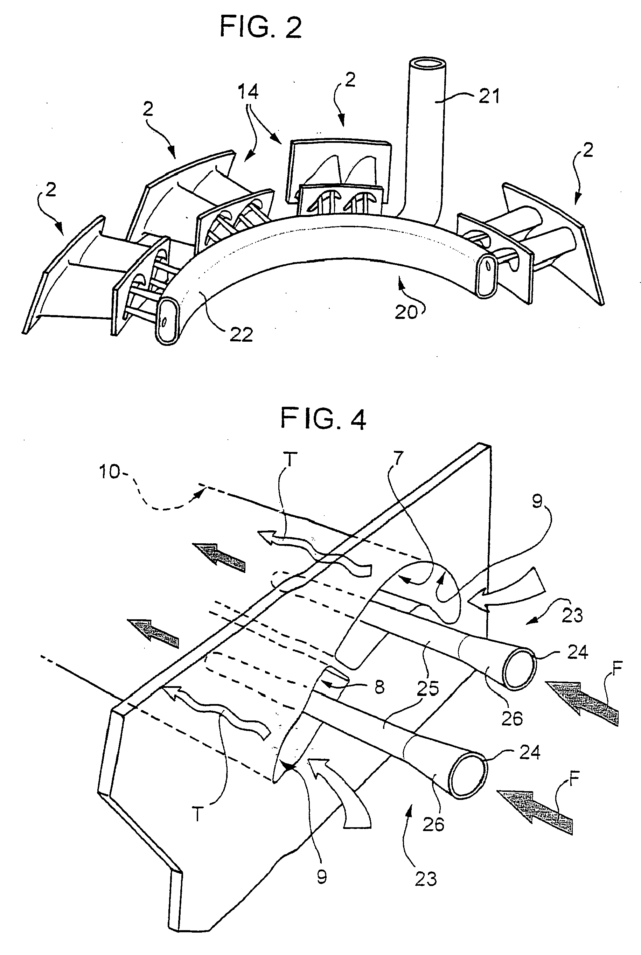

In the particular example described, the plant 1 comprises an external container 12 divided vertically via a horizontal perforated resting surface 13, on which the blades 2 are set alongside one another along a circular path to form a ring 14 of blades (Figures 1 and 2). According to a variant (not shown), the blades 2 are set up against one another so as to form one or more rows of blades.

Once again with reference to Figure 1, set underneath the resting surface 13 is a container 16 housing a granular coating material 18, activated in a way in itself known, to form a gaseous mixture 19 that flows upwards through the perforated resting surface 13, directly lapping the external surfaces of the blades 2, set on the same resting surface 13.

Once again set on the resting surface 13 and within the ring 14 of blades 2 is a distributor device 20, common to all the blades 2 and comprising a pipe 21 for delivery of a gaseous flow (more fully described in what follows), and a control unit 21a for control and regulation of the gaseous flow entering the delivery pipe 21, which is in itself known and forms part of the distributor device 20.

The distributor device 20 moreover comprises an annular manifold 22, set within the ring 14 of blades and above the surface 13 and communicating with the delivery pipe 21 and, for each passage 7, 8, a respective delivery nozzle 23.

With reference to Figure 4, each nozzle 23 has a portion 24 for attachment to the manifold 22, a terminal outlet stretch 25 inserted, with extensive radial play, within the corresponding passage 7, 8 through the corresponding inlet opening 9, and an intermediate tubular stretch 26 shaped like a truncated cone, tapered towards the corresponding outlet stretch 25.

Coating of the surfaces that delimit the blades 2 externally and the internal passages 7, 8 of the same blades 2 internally is obtained in the way described in what follows.

First of all, the blades 2 are distributed to form a ring around the manifold 22 by bringing the outlet stretches 25 of the nozzles 23, each to be engaged to the corresponding passage 7, 8, and then the material or coating agent 18 is activated in a known way and the gaseous mixture 19 is created, which comprises, in addition to the coating agent 18, also an inert transport gas, conveniently argon. The gaseous mixture 19 fills the casing 12 completely and laps the external surfaces of the blades 2 directly, after which, once again in a known way, there follows deposition of the coating agent on the external surfaces themselves. Simultaneously, via the control unit 21a and through the delivery pipe 21 there is introduced into the manifold 22 in a continuous or pulsating way with fixed or variable intermittence a flow F of just inert gas, conveniently argon. From the manifold 22, the inert gas traverses the attachment portions 24 at a given rate and is accelerated in the corresponding stretches 26 until it flows into the respective stretches 25 at a rate higher than the aforesaid given rate and is introduced from the stretches 25 themselves into intermediate points of the corresponding passages 7, 8. Following upon entry into the passages 7, 8, the flow of inert gas generates in the passages themselves corresponding entraining currents T directed towards the respective outlets 10 of the passages 7, 8 themselves, which entrain the gaseous mixture present in the casing 12 within the passages 7, 8 through the corresponding inlets 9.

In this way, a difference of pressure between the inlet and the outlet of each passage is generated dynamically, and a "rich" mixture is inserted continuously or in a pulsating way within the passage itself, so that also the internal surfaces of the blades 2 are always lapped by a homogeneous gaseous mixture always having the same amount of coating agent and, consequently, coated in the same way as the external surfaces to form, in this way, protective barriers having the same efficiency in any part of the blade treated including the ones in which in the absence of the currents T, the gaseous mixture would stagnate, with consequent progressive impoverishment.

From the foregoing, it emerges clearly how the simultaneous coating of the external surfaces and of the internal ones is obtained with an extremely simple and universal device, which, on the other hand, can be easily inserted in existing treatment plants, without requiring particular or substantial modifications of the existing plants themselves.

From the foregoing, it moreover emerges clearly that modifications and variations can be made to the device 20 described herein, without thereby departing from the sphere of protection defined by the annexed claims. In particular, the geometry of the manifold, and the number and arrangement of the delivery nozzles could be different, as well as the geometry of the delivery nozzles themselves, which could comprise thermally resistant but elastically or plastically deformable parts. In this regard, it is evident that between the manifold and the nozzles or between the delivery pipe 21 and the nozzles themselves interface elements could be provided, for example pipes or hoses or adaptable structures, designed to enable variation of the configuration of the nozzles and/or their replacement with other nozzles of a different type.

Once again from what has been described, it is then evident that the device 20 described or modified on the basis of what has just been set forth above can be used for the coating of any hollow metal items, which may even be geometrically very different from turbine blades, and in particular, for all those items that have internal elongated cavities and/or sections of small passage and, in general, cavities designed to define reservoirs or storage units for accumulation of the incoming gaseous mixture.

## Claims

1. A method for simultaneously coating internal and external surfaces of a metal item, said internal surfaces delimiting at least one passage having an inlet and an outlet, the method comprising the steps of feeding a gaseous mixture comprising a coating agent towards the external surfaces of the metal item and simultaneously towards said inlet, and being **characterized in that** sent in said passage is a gaseous flow different from said gaseous mixture for entraining the gaseous mixture within said passage.

2. The method according to Claim 1, **characterized in that** said gaseous entraining flow is sent within said passage through said inlet and towards said outlet.

3. The method according to Claim 2, **characterized in that** said gaseous entraining flow comprises an inert gas.

4. The method according to Claim 2 or Claim 3, **characterized in that** said gaseous entraining flow is without said coating agent.

5. The method according to Claim 4, **characterized in that** said gaseous entraining flow is fed simultaneously with the feed of said gaseous mixture and in a continuous way.

6. The method according to any one of Claims 1 to 3, **characterized in that** said gaseous entraining flow is fed simultaneously with the feed of said gaseous mixture and in a pulsating way.

7. The method according to any one of the preceding claims, **characterized in that** sending of said gaseous flow comprises the steps of feeding said gaseous flow towards said inlet at a first rate and bringing the rate of said gaseous flow to a second rate higher than said first rate at the moment of entry into said passage.

8. A plant for coating internal and external surfaces of a metal item simultaneously, said internal surfaces delimiting at least one passage having an inlet and an outlet, the plant comprising first means of advance for feeding a gaseous mixture comprising a coating agent towards the external surfaces of the metal item and simultaneously towards said inlet, and being **characterized in that** it moreover comprises second means of advance for feeding into said passage a gaseous flow different from said gaseous mixture for entraining the gaseous mixture within said passage.

9. The plant according to Claim 8, **characterized in that** said second means of advance comprise at least one delivery nozzle designed to extend through said passage for sending said gaseous flow towards said outlet.

10. The plant according to Claim 9, **characterized in that** said second means of advance comprise flow-regulating means for sending a gaseous flow towards said delivery nozzle in a continuous or pulsating way.

11. The plant according to any one of Claims 8 to 10, **characterized in that** said second means of advance moreover comprise first feeding means for feeding said gaseous flow towards said inlet at a first rate and rate-varying means for bringing the rate of said gaseous flow to a second rate higher than said first rate.

12. The plant according to Claim 11, **characterized in that** said first feeding means comprise a manifold common to a plurality of items to be coated and for each item to be coated at least one nozzle communicating with said manifold and designed to be inserted in the corresponding said inlet.

13. The plant according to Claim 12, **characterized in that** said rate-varying means comprise a converging portion set between said common manifold and each said nozzle.
